Europäisches Patentamt

European Patent Office

Office européen des brevets

(11) Publication number: **0 446 496 A2**

# EUROPEAN PATENT APPLICATION

(21) Application number: 90203443.8

(22) Date of filing: 21.12.90

(51) Int. Cl.⁵: **H01F 5/00, H01F 27/28, G01P 5/08, G01C 19/14**

(30) Priority: 23.01.90 NL 9000163

(43) Date of publication of application:
**18.09.91 Bulletin 91/38**

(84) Designated Contracting States:
**BE CH DE DK ES FR GB GR IT LI NL SE**

(71) Applicant: **Datawell B.V.**
**Zomerluststraat 4**
**NL-2012 LM Haarlem(NL)**

(72) Inventor: **Rademakers, Petrus Johannes, Ir.**
**Bellamylaan 1**
**NL-2111 CH Aerdenhout(NL)**

(74) Representative: **de Wit, Gerard Frederik, Ir. et al**
**Octrooi- en Merkenbureau De Wit B.V.**
**Breitnerlaan 146**
**NL-2596 HG Den Haag(NL)**

(54) Shielded magnetizing device and angular rate sensor in which such a device is used.

(57) The invention describes a device for generating a magnet field in a predetermined room, wherewith it is seen to it that outside said room no stray field of this magnet field occurs by providing, that an energizing coil (11) is surrounded by a compensation coil (12), which is coaxially therewith, wherewith the currents through the windings see to it that the external field is zero. Especially with a spherical winding with equal current energizing per length unit in the axis direction a proportionality between the current energizings of the energizing winding and the compensation winding is provided, which is inversely proportionate to the third power of the radii of these windings.

fig. 6

EP 0 446 496 A2

## SHIELDED MAGNETIZING DEVICE AND ANGULAR RATE SENSOR IN WHICH SUCH A DEVICE IS USED.

The invention relates to a device for generating a magnet field in a predetermined room, in which at least one energizing winding is mounted about said room and connected to a current source.

Such devices for generating a magnetic field are very well known and normally are indicated as coils or windings. It is also possible that a number of coils or windings in mutual cooperation form a field which may be moving, fluctuating or rotating or modulated in another way.

In all these cases one has also a component of this field outside the room in which the magnetic field is generated. Shielding by means of electromagnetic material has the disadvantage, that this will disturb also fields which are located outside the shield.

With very sensitive measurements, in which use is made of a magnet field, the field occurring outside the energizing winding may become disturbing, because there pick-up conductors and/or processing devices are located.

The invention aims to provide a device, with which a field generated in the room with a very high accuracy can be eliminated.

According to the invention this is attained by providing that outside said winding a compensation winding has been mounted which is coaxialy with the energizing winding, the currents through both windings being in proportion in such a way that outside the compensation winding the fields generated by the windings compensate each other.

An almost complete annihilation of the field outside the compensation winding or compensation windings is possible if it is provided that the windings are located on an ellipsoidal or spherical surface, each winding having a fixed number of turns per unity of length in the direction of the axis of the winding. In that instance it is theoretically possible to make the field outside the compensation winding exactly zero, the only deviation of this complete annihiliation being caused by not sufficiently finely coiling the bindings.

With spherical windings a complete compensation will be obtained, as further in this description will be demonstrated, if it is provided that the surfaces on which the windings are located are spherical and that the energizing currents of the windings have a proportion which is inversely proportionate to the third power of the radius of the spheres on which the windings are located.

In order to obtain in a simple way the possibility to separate the effects of each of the pairs of windings it can be provided that each pair coaxial windings is fed by an alternating current having a frequency which differs from the frequency of the current through each of the other pairs.

An important application of the invention is the case, that a magnet field is generated, be it in the form of an alternating field or not, which what concerns its direction, exactly corresponds to an external field for instance the earth magnet field. According to a further elaboration of the invention this can be attained by providing that modulation devices are present to control the current through the windings and that magneto meters control these modulators to let them output an alternating current, which is proportional to the magnet field strength measured in the direction of the axis of the considered winding.

An important application of the invention forms an angular rate sensor provided with a conducting liquid inertia mass contained in a device according to one or more of the claims 1-6. With an important application of such an angular rate sensor, namely measuring the orientation of an oceanographic measuring bouy, an extremely weak signal is obtained, so that disturbance by the generated magnet field is not allowed. Consequently a favourable embodiment of the invention is obtained by providing that the liquid inertia mass is contained in a spherical vessel and that three electrode pairs are present which each have an electrode near to the centre of the spherical inertia mass and an electrode near to the surface of this mass.

With this angular rate sensor it is preferably provided, that the output voltages of the electrode pairs are fed to three galvanically separated primary windings of a ring transformer with one secondary winding, said secondary winding having many times more turns than each of the primary windings. By this feature an additional saveguard against induced disturbing voltages is obtained.

A further feature to this effect consists in that between each electrode pair and the related primary windings of the ring transformer an upward transforming transformer is mounted.

According to a last improvement of such an angular rate sensor it preferably is provided, that the signal issued by the electrode pair or the electrode pairs is phase-sensitively detected and that a phase reference signal is derived from the current feeding the windings for generating a magnet field in the inertia mass.

The invention in the following will be elucidated on hand of the drawing, in which:

fig. 1 shows the mounting of a single electrode pair;

fig. 2 is a scheme to elucidate the generation of a magnet field with the direction of an external field;

fig. 3 schematically shows a coil for obtaining a homogeneous field;

fig. 4 shows a winding and a compensation winding for obtaining an almost completely fieldless external space;

fig. 5 schematically shows a pick-up with integrated ring core transformer; and

fig. 6 shows a scheme of a complete device according to the invention.

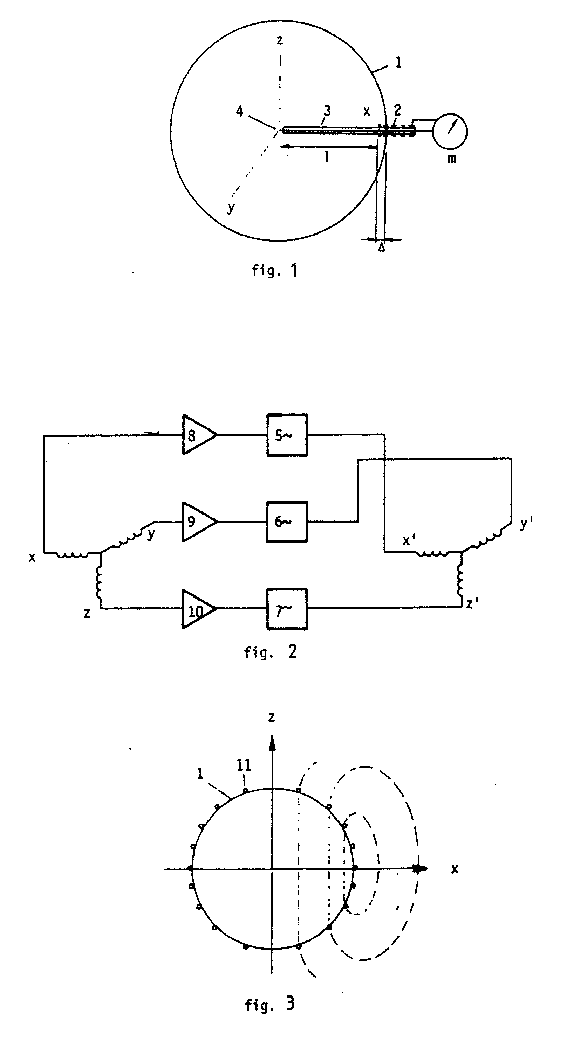

In fig. 1 schematically a preferred mounting has been shown of an electrode pair in a spherical vessel filled with mercury. Along the x axis runs a coaxial cable consisting of a conducting outer sheath 2, an insulating sheath 3 and a core of a conducting wire 4. The outer sheath protrudes from the outside over a small distance $\triangle$ into the sphere. The central wire 4 continues till near to the centre of the sphere, wherewith at that side a small piece of isolation has been removed, so that the inner wire 4 at that location contacts the mercury. The outer sheath also contacts over a small distance $\triangle$ the mercury, so that a circuit 4 - mercury - 2 is closed via the non-moving mercury. When the system and consequently the sphere 1 rotates, the conductor 4 will move in a magnet field, which goes through the sphere and consequently will generate an electro-motoric force. This equals $0,5 \, B\omega l^2$ if the magnet field runs in the direction of the z axis and the system rotates about this axis with the angular rate $\omega$.

In a complete system a unit analogous to the unit 2,3,4 is applied in the y axis and the z axis. The sum of the signals then equals $B\omega l^2$, independent on the orientation of the B vector in the x-y-z-system, as has been shown in the copending application "Angular rate sensor" which is based on the same priority application as the present application.

Fig. 2 shows a schema with which it is possible to transfer a magnet field into an alternating field with the same direction. Pick-up elements indicated with the mutually perpendicular axes x, y and z control amplifiers 8, 9 and 10, which via modulators 5, 6 and 7 energize the coils indicated with x', y' and z' for generating a magnet field which goes through the mercury mass.

In fig. 3 a winding 11 has been shown which is applied on a spherical surface 1, wherewith the number of turns of the winding 11 per length-unit in the direction of the z axis is always the same. This leads to a strictly homogenous field in the spherical room, which property also is valid for a possibly ellipsoidal shape of the winding. A homogenous field is important, because deviations of the homogenity of the field may give deviations of the measuring result which only difficultly can be corrected.

When the current through the winding 11 equals i ampère and per meter in the z-direction n turns are present, the magnet field generated in the sphere is

$$H_i = 2/3 \, ni = 2/3 \, \rho z \text{ ampère/meter}$$

in which $\rho_z$ is the energizing current per unit of length in the z-direction.

Outside the sphere a magnet field exists as if in the centre a magnet dipole moment m is present with the strength of

$$m = 4/3 \, \pi \, R^3 \rho_z$$

in which R is the radius of the sphere.

This is exactly true, provided the sphere has been coiled with infinite fineness.

In fig. 3 the winding about the z axis has been shown. Of course corresponding windings about the x axis and the y axis can be applied, wherewith it becomes possible to generate a magnet field the direction of which is determined by the proportion of the currents through the three windings.

If the earth field has been transferred into an alternating field in the neighbourhood of the pick-up elements an alternating field will be present having the same frequency as has the measuring signal. This may induce serious disturbances.

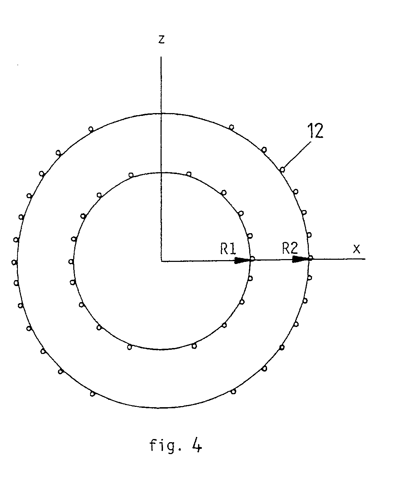

Because the picked-up signal is proportionate to dB/dt and with respect to B a phase difference of $90^°$ exists between both signals by means of phase sensitive demodulation already some suppression can be obtained. Nevertheless the exigences remain severe and for a practical realization it remains necessary to weaken the field outside the sensor. A stylish method is based in the potential theory in combination with spheres. By repeating the coiling indicated in fig. 3 with another radius, the configuration of fig. 4 is obtained.

If now about each of the axes x y z a second winding 12 of the same type is applied, wherewith the first winding is located on a sphere with a radius R1 and the second on a sphere with a radius R2 (vide fig. 4) the following is valid:

$$x > R_2: \qquad H_2 = 4/3 \; \pi \left( \rho_{1z} R_1^3 + \rho_{2z} R_2^3 \right) / \left( 4\pi \; x^3 \right)$$

$$x < R_1: \qquad H_0 = 2/3 \left( \rho_{1z} + \rho_{2z} \right)$$

We choose $\rho_{1z}$, $R_1$, $\rho_{2z}$ and $R_2$ such that:
or

$$\rho_{1z} R_1^3 + \rho_{2z} R_2^3 = 0$$

$$\rho_{2z} = -\rho_{1z} R_1^3 / R_2^3$$

This leads to:

$$H_0 = 2/3 \; \rho_{1z} \left( 1 - \frac{R_1^3}{R_2^3} \right) .$$

By this choice one attains at the cost of some energy an outer field ($x > R_2$) which is exactly zero, whereas the inside field ($x < R_1$) is finite and homogeneous. One and the other is only valid if winding is infinitely fine.

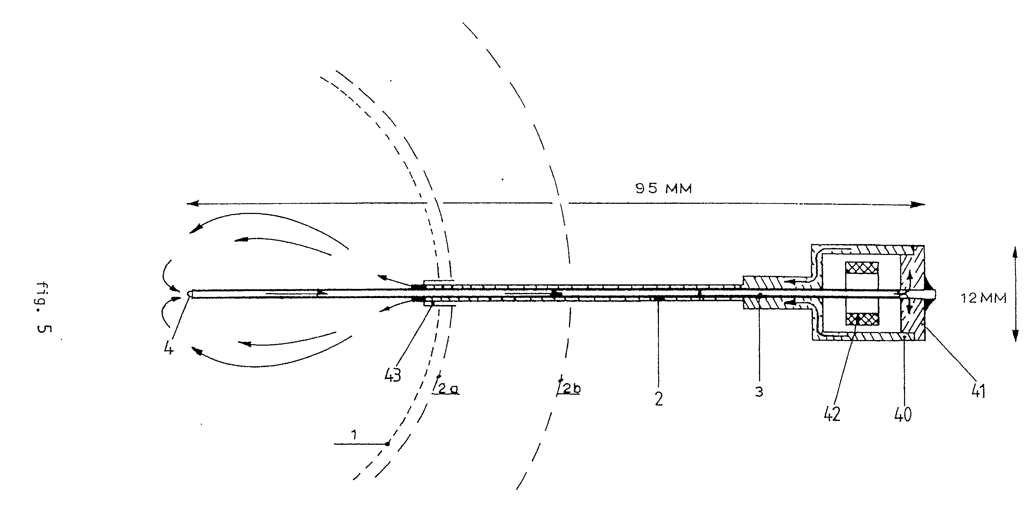

If now the pick-up devices and the processing devices are located outside the outer spherical winding, they cannot be influenced by disturbances induced by the magnet fields. The connections with the pick-up devices and the measuring devices from the sphere with radius $R_1$ up till the sphere with radius $R_2$ has then to be choosen such that at that location no nett voltage is induced, for instance by using as much as possible straight coaxial connections between both spheres. Fig. 5 shows a cross-section through a sensor as can be used with the invention.

The limitation of the spherical surface again has been indicated with 1, wherewith the spherical surface in which the core of the inner windings are located, has been indicated with 2a and the surface in which the centre line of the compensating windings is located, has been indicated with 2b. The central conductor again has been indicated with 4, the insulation with 3, the conducting sheath with 2 and the isolation laying here around with 43.

At its end turned away from the sphere the inner conductor 4 has been connected with a conducting plate 41, which is connected with a bowl -shaped body 40, which again is connected with the outer skin 3. About the conductor 4 within the body 40 a transformer core 42 has been applied on which a pick-up coil can be coiled. It is visible that the upper part of the inner conductor 4 together with 41 and 40 form a coaxial primary winding on a transformer core 42.

The resistance of the circuit 2, 41, 40, 3 and a bridging mercury portion is very small and for this reason generally a single turn around the transformer core 42 suffices.

Of course it is also possible to use the voltages in two other perpendicular directions for energizing of a transformer core corresponding to the transformer core 42.

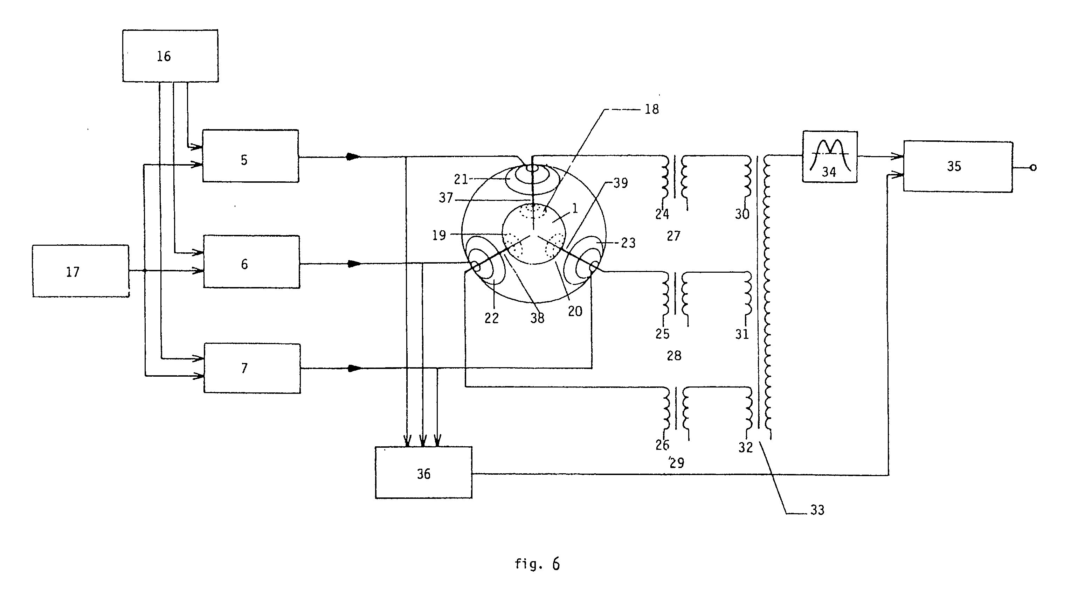

Finally in fig. 6 a scheme has been given of a complete device according to the invention. With 16 a magnetic pick-up has been indicated, which is fixedly coupled to a movable system and preferably is at a location where the directive field, normally the earth field, is not disturbed by parts of the system itself. Further an alternating current generator 17 is present and a number of modulators 5, 6 and 7, which modulate the alternating current in dependence on the magnetic field strengths determined by the magnetic pick-up 16 in the three different coordinate directions. The energizing currents of the modulators 5, 6 and 7 are, possibly after amplification, fed to three mutually perpendicular energizing windings 18, 19 and 20 and currents which are proportionate therewith to the compensation windings 21, 22 and 23.

The sensors 37, 38 and 39 which protrude into the mercury sphere 1 are connected via straight coaxial cables with the region outside the sphere of the compensation windings 21, 22 and 23. From here they are connected to the primary windings 24, 25 and 26 of upwardly transforming auxiliary transformers 27, 28 and 29, the secondary windings of which being connected to the primary windings 30, 31 and 32 of an adding transformer 33 which preferably is carried out as a ring transformer, which windings contain mostly only one turn.

The secondary winding of the sum transformer is via a band pass filter 34 connected to a phase-sensitive demodulator 35, which receives its phase-indication from an element 36, the voltage of which is derived from the energizing currents.

Because the measuring voltage induced by the rotation is proportionate to the field strength of the magnet field and possible pick-up voltages in the conductors are proportionate with the first derative of the magnet field, the phase-sensitive demodulation forms a very effective means to eliminate disturbance signals which have been picked-up from the generated alternating field.

The use of an energizing field with different frequencies is especially of importance if the application of the invention is used, with which the magnet field has been fixedly connected to a movable system. Then it is possible to separate the three mutually perpendicular signals in an easy way and one obtains a device which measures the angular rate about three axes moving with the system, which in totality is considerably simpler than three separate mutually perpendicular mounted devices.

For further particularities about the angular rate sensor itself reference is made to the co-pending application "Angular rate sensor", which is based on the same priority application as the present application.

## Claims

1. Device for generating a magnet field in a predetermined room, in which at least one energizing winding (11) is mounted about said room and connected to a current source, characterized in that outside said winding a compensation winding (12) has been mounted which is coaxial with the energizing winding, the currents through both windings being in proportion in such a way that outside the compensation winding the fields generated by the windings compensate each other.

2. Device according to claim 1, characterized in that the windings (11,12) are located on an ellipsoidal or spherical surface, each winding having a fixed number of turns per unity of length in the direction of the axis of the winding.

3. Device according to claim 1 or 2, characterized in that the surfaces on which the windings are located are spherical and that the energizing currents of the windings have a proportion which is inversely proportionate to the third power of the radii of the spheres on which the windings are located.

4. Device according to claim 2 or 3, characterized in that three mutually perpendicular energizing windings (18,19,20) and coaxially with them three compensation windings (21,22,23) are present.

5. Device according to claim 4, characterized in that each pair coaxial windings is fed by an alternating current having a frequency which differs from the frequency of the current through each of the other pairs.

6. Device according to one or more of claims 1-5, characterized in that modulation devices are present to control the current through the windings and that magneto meters control these modulators to let them output an alternating current, which is proportionate to the magnet field strength measured in the direction of the axis of the considered winding.

7. Angular rate sensor provided with a conducting liquid inertia mass contained in a device according to one or more of the claims 1-6, characterized in that the liquid inertia mass (1) is contained in a spherical vessel and that three electrode pairs are present which each have an electrode near to the centre of the spherical inertia mass and an electrode near to the surface of this mass.

8. Angular rate sensor according to claim 7, characterized in that the output voltages of the electrode pairs (37,38,39) are fed of three galvanically separated primary windings (30,31,32) to a ring transformer with one secondary winding (33),said secondary winding having many times more turns than each of the primary bindings.

9. Device according to claim 8, characterized in that between each electrode pair (37,38,39) and the related primary windings (30,31,32) of the ring transformer an upward transforming transformer (27,28,29) is mounted.

10. Angular rate sensor according to claim 7, 8 or 9, characterized in that the signal issued by the electrode pair or the electrode pairs is phase-sensitively detected and that a phase reference signal is derived from the current feeding the windings (11,12) for generating a magnet field in the inertia mass.

fig. 1

fig. 2

fig. 3

fig. 4

EP 0 446 496 A2

fig. 5

9

fig. 6